# EUROPÄISCHE PATENTSCHRIFT

(11) **EP 1 503 615 B1**
(45) Veröffentlichungstag und Bekanntmachung des Hinweises auf die Patenterteilung: **13.06.2007**
(21) Anmeldenummer: 04016767.8
(22) Anmeldetag: 15.07.2004
(51) Int. Cl.: H05K 1/02, H05K 7/20

(54) **Leiterplatine mit gekühltem Baustein, insbesondere SMD-Baustein**
Circuit board having a cooled component, particularly a SMD-component
Panneau à circuit avec un composant refroidi, en particulier un composant CMS

(30) Priorität: 31.07.2003 DE 10335129
(43) Veröffentlichungstag der Anmeldung: 02.02.2005
(73) Patentinhaber: Kathrein-Werke KG, 83022 Rosenheim (DE)
(72) Erfinder: Häntsch, Ralf, 83064 Raubling (DE); Meishammer, Adalbert, 83026 Rosenheim (DE)
(74) Vertreter: Flach, Dieter Rolf Paul

(56) Entgegenhaltungen:
- EP-A- 0 913 861
- DE-A1- 3 315 583
- DE-C1- 19 916 010
- DE-U1- 20 301 773
- FR-A- 2 413 016
- GB-A- 2 345 576
- US-A1- 2002 050 380
- US-B1- 6 411 516
- KONRAD SCHEUER: ELEKTRONIK PRAXIS ELEKTROMECHANIK II, September 2005 (2005-09), Seiten 84-86,

## Beschreibung

Die Erfindung betrifft eine Leiterplatine mit einem gekühlten Baustein, insbesondere SMD-Baustein nach dem Oberbegriff des Anspruches 1.

Bekanntermaßen werden Leiterplatinen nicht nur mit passiven Bauelementen, sondern häufig auch mit aktiven Bauelementen bestückt, die im Einsatz durchaus nicht unerhebliche Wärmemengen erzeugen. Bei derartigen aktiven und hitzeerzeugenden Bauelementen kann es sich um SMD-Bausteine handeln, beispielsweise um Verstärkerbausteine.

Von daher ist bekannt, dass derartige elektrische, d.h. aktive und wärmeerzeugende Bausteine, wie sie beispielsweise für die SMD-Montage konzipiert sind, nur in bestimmten Umgebungsbedingungen eingesetzt werden können. Dies erfordert insbesondere eine entsprechende Kühlung.

So ist es beispielsweise üblich, einen SMD-Baustein an seiner Unterseite mit einer metallischen Kühl- und Kontaktfläche zu versehen, über die Wärme nach unten hin abgeführt werden soll. Da der Baustein allerdings auf der Leiterplatine selbst sitzt, ist bereits vorgeschlagen worden, in diesem Bereich die Leiterplatine mit einer Vielzahl feinster, durchkontaktierter Öffnungen zu versehen. Während des Schwalllötens gelangt dann durch diese Perforationen Zinn bis zur Kühl-Kontaktfläche auf der Unterseite des SMD-Bausteines, so dass eine am SMD-Baustein vorgesehene lötfähige Kontaktunterseite über die Perforation mit der Platinenunterseite verlötet ist. Dort wird dann üblicherweise noch eine Wärmeleitfolie aufgebracht, um die unebene Oberfläche auszugleichen. Die Leiterplatine kann mittels Schrauben auf einem darunter befindlichen Kühlkörper oder Gehäuseteil aufgeschraubt werden, so dass der SMD-Baustein mit seiner auf der Unterseite (platinenseitig) vorgesehenen metallischen Fläche ohne Luftspalt mit dem Kühlkörper verbunden ist.

Anstelle des vorstehend erläuterten Schwalllötens ist es ebenso möglich, vor dem SMD-Bestücken auf der Unterseite des Bausteines Lötpaste aufzubringen, so dass beim nachfolgenden Reflow-Löten das Lot aufgeschmolzen und die Kühl-Kontaktfläche auf der Unterseite des Bausteines mit der Leiterplatine verlötet wird. Aber auch hierdurch ist der Kühleffekt durchaus begrenzt, was insbesondere dann große Probleme aufwirft, wenn die Bausteine und insbesondere die SMD-Bausteine aufgrund höherer Leistungen größere Wärmemengen produzieren.

Eine Leiterplatine mit einem darauf befindlichen zu kühlenden, elektronischen Baustein ist auch aus der DE-A1-33 15 583 bekannt geworden. Um eine gute Kühlwirkung zu gewährleisten, ist in einem Träger oder einer Leiterplatine ein Fenster vorgesehen, in welchem ein metallischer Kühlblock positioniert wird, der dieses Fenster zumindest in seiner wesentlichen Dicke durchragt. Auf der Oberseite des Kühlblockes ist der zu kühlende Baustein mit einer dünnen Klebeschicht befestigt. Der zu kühlende Baustein kann dann über gebondete Drähte mit Kontaktabschnitten auf der Leiterplatine elektrisch angeschlossen werden.

Auf der Unterseite des Kühlbockes ist dann ein Kühlblech vorgesehen, das beispielsweise durch Löten oder Punkten mit dem Kühlblech verbunden sein kann. Der Abstand zwischen der Oberseite des Kühlbleches und der Unterseite der Leiterplatine benachbart zum Kühlblock kann über einen elastischen Kleber ausgefüllt sein.

Ein weitgehend vergleichbarer Aufbau ist auch aus der US-A-5 734 555 bekannt. Dort ist ein integrierter Baustein über eine Klebeschicht mit einem Kühlblock in Kontakt stehend angeordnet, wobei der Kühlblock ebenfalls wieder ein Fenster in der Trägeranordnung durchragt.

Eine demgegenüber verbesserte Leiterplatine mit einem gekühlten Baustein, insbesondere einem gekühlten SMD-Baustein, ist aus der DE-A1-100 64 221 bekannt geworden. In einer Leiterplatine ist ebenfalls eine Öffnung vorgesehen, in welcher ein wärmeleitfähiges Einlegeteil eingefügt ist. Gemäß dieser gattungsbildenden Vorveröffentlichung wird vorgeschlagen, das Einlegeteil mit der Kontakt- oder Kühlfläche an der Unterseite des zu kühlenden Bausteines zu verlöten. Auf der Leiterplatinenunterseite ist zumindest ein Plättchen befestigt, welches die Öffnung in der Leiterplatine überdeckt. Dieses eine Plättchen ist oder die gegebenenfalls vorgesehenen beiden Plättchen sind so ausgebildet, dass die der Leiterplatine und damit dem Einlegeteil zugewandt liegende Seite des benachbart liegenden Plättchens lötfähig ist, während die der Leiterplatine abgewandt liegende Seite des zumindest einen Plättchens oder des zuunterst angeordneten Plättchens im Falle von zumindest zwei Plättchen nicht-lötfähig oder zumindest lotabweisend sind.

Obgleich damit gegenüber früheren Lösungen eine verbesserte Kühlwirkung möglich ist, ist der gesamte Aufwand, insbesondere der material- oder herstellungsbedingte Aufwand, vergleichsweise hoch.

Schließlich sind noch eine Reihe weiterer Vorveröffentlichungen bekannt, bei denen ein zu kühlendes Bauteil oberhalb einer in der Leiterplatine eingebrachten Öffnung positioniert werden soll, wobei im Öffnungsbereich in der Leiterplatine ein entsprechender Kühlkörper zumindest zur Weiterleitung zu einer unterhalb der Leiterplatine vorgesehenen Kühlkörpereinrichtung vorgesehen ist. Es handelt sich dabei beispielsweise um die Veröffentlichungen DE-U1-203 01 773, DE-C1-199 16 010, US-B1-6 411 516 und DE-A1-102 14 311. Dabei ist insbesondere in der DE-A1-203 01 773 eine elektrische Einrichtung mit einer Leiterplatine gezeigt, auf welcher ein elektrischer Baustein mit Anschlussfüßchen angeordnet ist. Unterhalb des quaderförmigen Bausteins ist ein kreisförmiger Kühlkörper angeordnet, der von dem aufgesetzten Baustein völlig überdeckt wird.

Bei all diesen zuletzt genannten Vorveröffentlichungen ist jedoch das Kühlelement mit der Kontakt-Kühlfläche lediglich gekoppelt, aber nicht verlötet.

Aufgabe der vorliegenden Erfindung ist es von daher, eine verbesserte Leiterplatine mit einem verbesserten Kühleffekt für einen zu kühlenden Baustein, insbesondere SMD-Baustein zu schaffen, bei der die gesamte Anordnung vergleichsweise einfach aufgebaut ist, dabei gleichwohl noch eine verbesserte Kühlleistung gegenüber vorbekannten Lösungen möglich ist und die stoffschlüssige Verbindung zwischen Bautein-Kühlblock und Einpressteil beim Reflow-Löten stattfindet.

Die Aufgabe wird erfindungsgemäß entsprechend den im Anspruch 1 angegebenen Merkmalen gelöst. Vorteilhafte Ausgestaltungen der Erfindung sind in den Unteransprüchen angegeben.

Es hat sich nämlich gezeigt, dass bei den bisher bekannten Lösungen nicht sichergestellt werden kann, dass beim Reflow-Löten der Kühlblock des SMD-Bauteiles, das Einpressteil und die Lötpaste gleichzeitig auf die notwendige Löttemperatur erwärmt und somit stoffschlüssig verbunden werden können.

Der erfindungsgemäße Erfolg lässt sich dadurch realisieren, dass in dem in der Leiterplatinenöffnung positionierten Einpressteil zumindest eine und vorzugsweise mehrere Durchbruchsöffnungen vorgesehen sind. Dies bietet den wesentlichen Vorteil, dass während des Reflow-Lötens Wärme durch Konvektion und Strahlung von den im Reflow-Lötofen unten angebrachten Wärmequellen zu dem im SMD-Bauteil integrierten Kühlkörper gelangen kann. Alternativ und bevorzugt kumulativ lassen sich die erfindungsgemäßen Vorteile auch dadurch realisieren, dass der als Einpressteil in der Leiterplatinenöffnung positionierte Kühlkörper zumindest in einer Richtung so groß dimensioniert ist, dass er die entsprechende Länge des zu kühlenden Bauteiles überragt. Dadurch wird das Einpressteil nicht mehr vollständig von dem Kunststoffgehäuse des SMD-Bauteiles überdeckt und auch die im Reflow-Lötofen oben angebrachten Wärmequellen tragen effektiv zur Aufheizung des Einpressteiles bei. Dabei überragt das Einpressteil den zu kühlenden Baustein in dessen Längsrichtung, wobei die Anschlussfüßchen an dem Baustein an zwei quer zur Längsrichtung des Bauteils gegenüberliegenden Seiten vorgesehen sind.

In einer bevorzugten Weiterbildung der Erfindung ist vorgesehen, dass das Kühlplättchen, welches teilweise nachfolgend auch als Kühlblock bezeichnet wird, sowie die entsprechende Leiterplatinenaussparung, in welche dieses Kühlplättchen oder dieser Kühlblock eingefügt wird, so ausgebildet sind, dass das Kühlplättchen bzw. der Kühlblock in diese Leiterplatinenaussparung eingepresst wird. Das heißt, das Kühlplättchen ist mechanisch fest in der Leiterplatinenaussparung verankert. Das Kühlplättchen bzw. der Kühlblock überragt dabei nicht die Leiterplatten-Bestückungsebene. Dabei ist ferner zu berücksichtigen, dass der Abstand der an der Unterseite des SMD-Bauteiles ausgebildeten Kontakt-Kühlfläche bis zur Leiterplatine und damit der Lötebene wegen Fertigungstoleranzen zwischen 0 mm bis 0,2 mm erfahrungsgemäß differieren kann. Durch das eingesteckte Kühlplättchen dürfen dabei keine das SMD-Bauteil gefährdenden mechanischen Kräfte ausgeübt werden. Bezüglich der gewünschten festen mechanischen Verankerung des Kühlblockes ist dieser und/oder der den Kühlblock umgebende Rand in der Leiterplatine mit Vorsprüngen bzw. Vertiefungen versehen, vorzugsweise vorstehenden Spitzen, Riffelungen etc., die eine gute Verpresswirkung zwischen Kühlblock und Leiterplatine unterstützt. Bevorzugt sind die Vorsprünge oder Spitzen am Kühlblock ausgebildet, so dass der Kühlblock beim Einpressen in die Leiterplatinenaussparung sich teilweise in das Leiterplattenmaterial einkerben bzw. darin eindringen kann. Dadurch ergibt sich eine besonders günstige Zentrierung des Kühlblocks in der Leiterplattenaussparung. Hierdurch ergibt sich nicht nur eine optimale Fixierung des Kühlblocks, sondern auch eine einfache Möglichkeit zur Erzielung eines Toleranzausgleiches.

Unterhalb des Bauelementes, also auf der zum SMD-Bauteil anderen Leiterplatinenseite, ist ein Kühldom angeordnet, der bevorzugt Teil des Gehäuses ist. Dadurch kann die Wärme optimal über das Gehäuse nach außen abgeleitet werden.

In einer bevorzugten Ausführungsform kann zwischen der Unterseite des Kühlbockes und dem damit in Kontakt tretenden Kühldom noch eine gut wärmeleitfähige Kühlfolie zwischengefügt sein, um eine exzellente Wärmeleitung vom Bauelemente-Kühlblock zu dem Gehäuse ohne Verschlechterung durch einen geringsten Luftspalt zu gewährleisten.

In einer bevorzugten Ausbildung der Erfindung ist ferner vorgesehen, dass der Umfangsspalt zwischen dem Kühlbock und dem Leiterplattenmaterial, welcher die Leiterplattenaussparung umgrenzt, so dimensioniert ist, dass hier der Kühlblock und die Leiterplatte miteinander verlötet werden können. Dabei ist es grundsätzlich möglich, den Kühlbock mit der Kühlkontaktfläche auf der Unterseite des Bauelementes unter Verwendung von Lötpaste durch Reflow-Löten, unter Verwendung von Lötpaste durch Schwalllöten oder durch Verwendung von Perforationen im Kühlblock mittels Schwalllöten zu verlöten.

Da bei dem zu kühlenden Baustein, insbesondere SMD-Baustein, der Abstand zwischen der Unterseite des Bausteins und der Leiterplattenkontaktfläche durchaus in Bruchteilen eines Millimeters unterschiedlich ausfallen kann, ist bevorzugt zur Erzielung einer optimalen Verlötwirkung zwischen der Kontaktkühlfläche auf der Unterseite des Bausteines und des Kühlbockes vorgesehen, dass die Lötpaste nur in Form von nebeneinander angeordneten Lötpunkten oder Lötpads aufgetragen wird, vorzugsweise mit einer Maske oder Schablone. Beim nachfolgenden Löten, insbesondere beim Reflow-Löten oder auch beim Schwalllöten, besteht daher die Möglichkeit, dass sich bei geringem Abstand die punkt- oder rasterförmig aufgetragene Lötpaste unter Verringerung ihrer Gesamthöhe oder -dicke stärker flächig ausbreiten kann.

Ebenso kann in einer Weiterbildung der Erfindung vorgesehen sein, dass der als Einpressteil gestaltete Kühlblock zumindest partiell mit der Leiterplatine verlötet ist. Dies kann beispielsweise dadurch erfolgen, dass Lötpaste im Bereich des Spaltes zwischen Kühlblock und Leiterplatine punkt- oder padweise oder in sonstiger Form aufgetragen oder aufgedruckt wird, so dass beim Reflow-Löten dann dieser Spalt partiell geschlossen wird. Ebenso kann vorgesehen sein, dass bei Durchführung eines Schwalllötens von unten her Lot in die Spalte eindringt und diese Spalte schließt.

Für den als Einpressteil gestalteten Kühlblock kann es sich als günstig erweisen, die nach außen vorstehenden Vorsprünge oder Spitzen mit einer Abschrägung oder Einführschräge zu versehen, um das Einpressteil zumindest in einer Teilhöhe in die Leiterplatinenaussparung einzusetzen und durch weiteres Einpressen dann die Verkeilung bzw. Verpressung unter Einkerbung der Spitzen in das Leiterplatinenmaterial zu gewährleisten. Dazu besteht das Einpressteil bevorzugt aus Metall.

Schließlich kann in einer Weiterbildung auch vorgesehen sein, dass das Einpressteil einen Bund und gegebenenfalls auch eine umlaufende Nut aufweist. Die Nut dient zum einen der verbesserten Herstellung der nach außen stehenden Vorsprünge oder Rillen. Der Bund dient gleichzeitig der Begrenzung der Einpress- bzw. Eintauchtiefe des Kühlblockes in das Leiterplatinenmaterial.

Der Einpresskühlblock kann insbesondere bei Ausbildung eines Bundes die unten liegende Leiterplatinenebene überragen.

Schließlich können auch weitere Anpassungen vorgenommen werden, beispielsweise dadurch, dass eine Wärmeleitfolie zwischen dem Einpressteil in Form des Kühlblocks und dem vorzugsweise zu einem Gehäuse gehörenden Kühldom vorgesehen ist. Dadurch können auch geringstfügige Niveauunterschiede an den aufeinander liegenden und an sich weitgehend glatten Flächen ausgeglichen werden, um auch geringfügigste Lufteinschlüsse und Luftspalten zu vermeiden. Insgesamt lässt sich also festhalten, dass im Rahmen der Erfindung der thermische Widerstand gegenüber der herkömmlichen Lösung weiter verringert werden konnte. Diese Vorteile können dabei bei geringeren Kosten erzielt werden, da beispielsweise das erwähnte Einpressteil als Stanzteil, Drehteil oder als Gussteil ausgebildet sein kann. Schließlich lässt sich im Rahmen der Erfindung eine ebene Fläche auf der Lötseite des Kühlblocks, also auf dessen Unterseite realisieren, wodurch ein direkter Kontakt zu dem die Wärme abführenden Gehäuse (Kühldom) möglich wird. Schließlich lässt sich aber auch ein hoher Anpressdruck zwischen Kühlblock und Gehäuse ermöglichen, ohne dass das zu kühlende Bauelement belastet wird.

Anhand der geschilderten Ausführungsvarianten ist auch ersichtlich, dass nicht alle Seitenflächen des verwendeten Kühlblocks lötfähig sein müssen, weshalb der Wärmeleitblock dann beim Schwalllöten nicht abgedeckt werden muss, um eine ebene Kontaktfläche zu erhalten. Wenn beispielsweise die dem SMD-Bauteil abgewandte Seite des Wärmeleitblocks nicht lötfähig ist, bleibt gleichwohl diese Fläche auch ohne zusätzliche Abdeckmaßnahmen nach dem Schwalllöten eben. Ferner kann der Kühlblock aber auch an allen Seitenflächen lötfähig sein. In diesem Fall kann der Kühlblock dann leicht mit der Leiterplatine verlötet werden.

Die Erfindung wird nachfolgend anhand von Ausführungsbeispielen näher erläutert. Dabei zeigen im Einzelnen:
- Figur 1:: eine schematische perspektivische Unteransicht eines zu kühlenden SMD-Bauteiles;
- Figur 2:: eine schematische Querschnittsdarstellung einer Leiterplatine mit einem darauf mit seinen "Füßen" angelöteten SMD-Baustein;
- Figur 3:: eine schematische perspektivische Darstellung eines erfindungsgemäßen Einpressteiles;
- Figur 4:: eine schematische Querschnittsdarstellung durch ein Ausführungsbeispiel eines Einpressteiles;
- Figur 5:: eine schematische perspektivische Darstellung der Anbringung von Lötpads auf der Leiterplatine und eines in der Leiterplatinenöffnung sitzenden Einpressteiles, bevor das zu kühlende SMD-Bauteil an seinen "Füßchen" auf der Leiterplatine angelötet wird;
- Figur 6:: eine schematische Querschnittsdarstellung vergleichbar jener nach Figur 2, bei der das Einpressteil unter Zwischenschaltung einer Wärmeleitfolie auf einem Kühldom aufgesetzt ist;
- Figur 7:: eine perspektivische Darstellung eines abgewandelten Einpressteiles mit einer Perforation;
- Figur 8:: eine weitere perspektivische Darstellung eines abgewandelten Einpressteiles;
- Figur 9:: ein nochmals abgewandeltes Einpressteil, hergestellt aus einem Drehteil;
- Figur 10:: eine schematische Querschnittsdarstellung vergleichbar jener nach Figur 6, jedoch unter Verwendung des unter Figur 9 wiedergegebenen Einpressteiles;
- Figur 11:: ein nochmals abgewandeltes Einpressteil in perspektivischer Darstellung; und
- Figur 12:: die perspektivische Darstellung eines SMD-Bauteiles auf einer Leiterplatine mit einem unterhalb des Bauteiles in einer Leiterplatinenöffnung vorgesehenen Einpressteil, welches das SMD-Bauteil in Längsrichtung überragt.

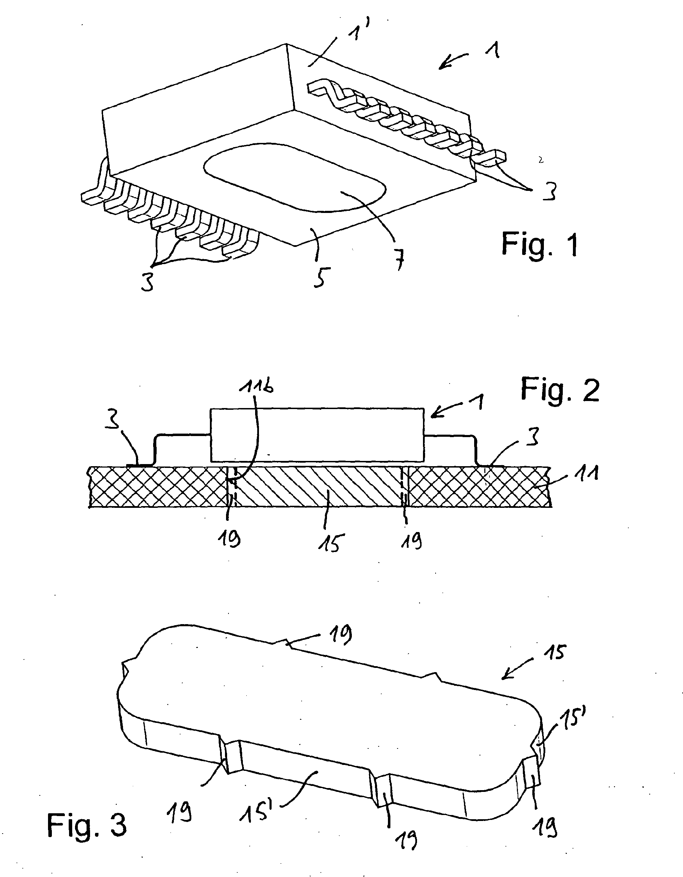

In Figur 1 ist in schematischer perspektivischer Darstellung ein zu kühlendes Bauteil 1 gezeigt, welches im gezeigten Ausführungsbeispiel aus einem SMD-Bauteil 1 besteht. Es ist im wesentlichen quaderförmig gestaltet und weist an zwei gegenüberliegenden Seiten 1' eine Vielzahl von elektrischen Anschlussfüßchen 3 auf.

Auf der Unterseite 5 des Bauteils 1 ist eine Kontakt-Kühlfläche 7 ausgebildet, die letztlich dazu dient, die im Betrieb des SMD-Bauteils erzeugte Wärme über diese Kontakt-Kühlfläche 7 abzuleiten.

In Figur 2 ist ein erstes Ausführungsbeispiel in schematischer Querschnittsdarstellung wiedergegeben. Darin ist im Querschnitt eine Leiterplatine 11 zu erkennen, in welcher eine Leiterplatinenöffnung 13 in Form eines Fensters eingearbeitet ist. Diese Leiterplatinenöffnung 13 ist in der Regel größer als die Kontakt-Kühlfläche 7 des darüber befindlichen Bauteiles 1.

Aus der Querschnittsdarstellung gemäß Figur 2 ist auch zu ersehen, dass die seitlichen Anschlussfüßchen 3 des SMD-Bauteils in der Regel so abgewinkelt sind, dass deren Anschlussfläche 3' an den Anschlussfüßchen 3 nicht zwingend auf der gleichen unteren Niveaufläche der Unterseite des Bauteiles 1, sondern demgegenüber tiefer liegend ausgebildet sein kann. Dies hat im montierten Zustand die Folge, dass die Unterseite 5 des SMD-Bauteiles 1 geringfügig oberhalb der oberen Kontaktfläche 11a der Leiterplatine 11 zu liegen kommt.

In der erwähnten Leiterplatinenöffnung 13 ist beispielsweise ein Einpressteil 15 in Form eines Kühlplättchen oder eines Kühlblocks positioniert. Dazu weist das in Figur 3 in einer schematischen perspektivischen Darstellung wiedergegebene Einpressteil 15 eine Formgebung in Draufsicht auf, die der Formgebung der Leiterplatinenöffnung 13 nachgebildet sein kann. Wie allerdings aus Figur 3 auch zu entnehmen ist, sind am Umfangsrand 15' des Einpressteiles 15 mit Seitenversatz mehrere vorstehende Spitzen, Keile, Stege oder Rippen 19 oder dergleichen vorgesehen, die im Querschnitt beispielsweise winkel- oder dachförmig gestaltet sein können.

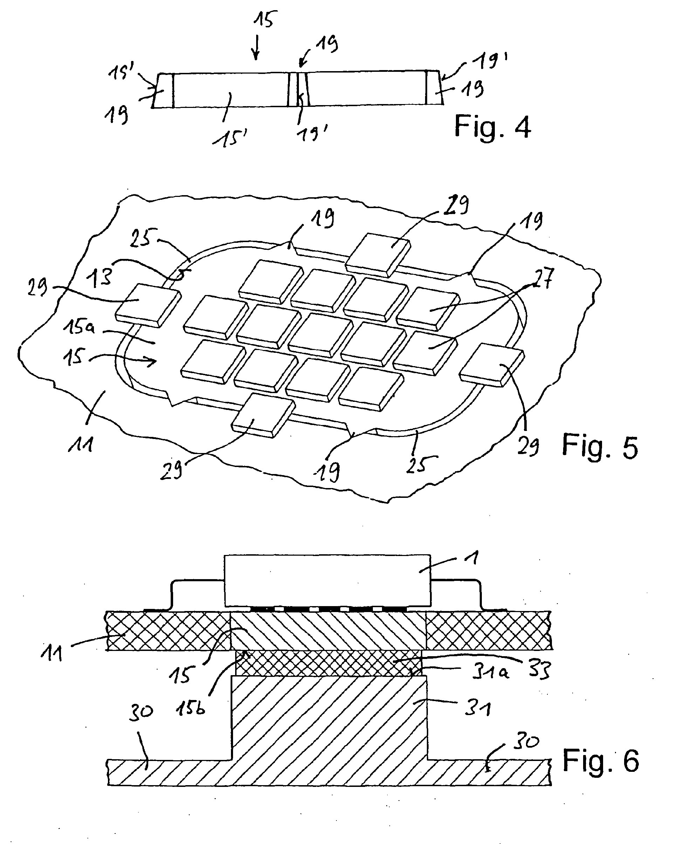

Wie dabei aus der schematischen Querschnittsdarstellung gemäß Figur 4 auch zu entnehmen ist, ist das Einpressteil 15, d.h. der Kühlblock 15 bevorzugt so gestaltet, dass dessen Spitzen, Keile, Stege oder Rippen oder dergleichen mit einer Einführungsschräge 19' versehen sind, so dass sich insgesamt in Einsteckrichtung eine keilförmige, d.h. leicht differgierende Ausgestaltung der zu äußerst liegenden Kanten 19 ergibt. Dabei ist das Außenmaß zwischen zwei gegenüberliegenden Kanten oder zwischen einer Kante und einem etwa gegenüberliegenden Abschnitt des Umlaufrandes 15' des Einpressteiles 15 so bemessen, dass das entsprechende Abstandsmaß in Einsteckrichtung geringfügig kleiner ist als das lichte Innenmaß an betreffender Stelle in der Leiterplattenöffnung 13, und dass nach anfänglichem Einstecken des Einpressteiles 15 in die Leiterplattenöffnung 13 dann die nach außen vorstehenden Spitzen, Keile, Stege oder Rippen 19 mit ihrer nach außen vorstehenden Kante 19' auf den angrenzenden Leiterplatinen-Öffnungsrand 11b auflaufen, so dass sich bei weiterer Einschub- und Einpressbewegung des Einpressteiles 15 in die Leiterplatinenöffnung 13 nunmehr die nach außen vorstehenden Kanten 19 immer tiefer in das Leiterplatinenmaterial vom Leiterplatinen-Öffnungsrand 11b aus einkerben. Dadurch wird in der Innenposition des Einpressteiles 15 ein fester Presssitz dieses Einpressteiles 15 in der Leiterplatinen-öffnung 13 gewährleistet.

Dabei ist das auch als Kühlblock oder Kühlplättchen bezeichnete Einpressteil 15 nicht dicker als die Leiterplatte. Wird dabei mit einem Druckstempel gearbeitet, der von unten her auf das Einpressteil 15 aufgesetzt wird, wobei der Druckstempel eine größere Kontur aufweist (zumindest abschnittsweise) als die Leiterplatinenöffnung 13, so kann dadurch gewährleistet werden, dass dieses Einpressteil 15 nicht weiter in die Leiterplatinenöffnung 13 eingeschoben wird, bis die unten liegende Niveaufläche 15" des Einpressteiles 15 exakt auf Höhe der Niveaufläche 11c auf der Unterseite der Leiterplatine 11 ist.

In der Darstellung gemäß Figur 2 ist eine Querschnittsdarstellung gewählt, bei der der Querschnitt durch zwei gegenüberliegende Spitzen, Keile, Stege oder Rippen 19 oder dergleichen hindurchläuft. In den Zwischenräumen zwischen zwei benachbarten Spitzen 19 verbleibt dann ein Spalt 25 zwischen dem Umfangsrand 15' des Einpressteiles 15 und dem benachbarten Leiterplatinen-Öffnungsrand 11b im Bereich der Leiterplatinenöffnung 13.

In Figur 5 ist die Leiterplatine 11 ausschnittsweise mit dem im Bereich der Leiterplatinenöffnung 13 eingepressten Einpressteil 15 wiedergegeben, und zwar bevor das SMD-Bauteil 1 aufgelötet ist. Dabei ist aus Figur 5 zu entnehmen, dass letztlich zur Herstellung einer guten Lötverbindung zwischen Kontakt-Kühlfläche 7 des SMD-Bauteiles 1 und der Oberseite 15a des darunter befindlichen, aus Metall bestehenden Einpressteiles 15 (mit einer lötfähigen Materialzusammensetzung oder zumindest einer lötfähigen Oberflächenschicht) vorzugsweise mit einer Folienmaske eine Vielzahl von Lötpasten-Punkten 27 oder Lötpasten-Pads 27 aufgetragen werden, die unter Ausbildung eines Abstandes zueinander angeordnet sind. Darüber hinaus sind weitere Lötpasten-Stellen oder -Pads 29 vorgesehen, die zumindest unmittelbar benachbart zu dem erwähnten Abstandsspalt 25 oder sogar den Abstandsspalt 25 überdeckend aufgetragen werden. Zum Setzen dieser Lötpads können bekannte Techniken zum Einsatz kommen.

Anschließend kann dann das SMD-Bauteil 1 auf die Leiterplatine aufgesetzt werden.

Die so vorbereitete Leiterplatine kann nunmehr einem Reflow-Lötvorgang zugeführt werden. Dabei wird die gesamte Anordnung so aufgeheizt, dass die Lötpasten-Stellen fließfähig werden und entsprechend dem vorgegebenen Abstandsspalt zwischen der Unterseite 5 des SMD-Bauteils 1 und der oberen Leiterplatinenfläche 11a unter Vergrößerung ihrer gesamten Fläche auseinander fließen, bis eine volumenmäßige Anpassung an den vorhandenen Abstandsspalt 25 gegeben ist. Die Lötpastenstellen 29 im Bereich des Abstandsspaltes 25 führen dazu, dass nunmehr auch noch fließfähiges Lot in diesen Abstandsspalt 25 eindringt und den Umfangsrand 15' des Einpressteiles 15 mit den angrenzenden Leiterplatinen-Öffnungsrand 11b durch das Lötmittel verbindet.

Die Leiterplatine selbst ist in praktischem Einsatz beispielsweise so in einem Gehäuse angeordnet, dass der als Einpressteil 15 dienende Kühlblock oder das Kühlplättchen flächig auf einem Kühldom 31 aufliegt, welcher bevorzugt Teil eines Gehäuses 30 oder einer Gehäusewandung 30 ist. Die vom SMD-Bauteil ausgehende Wärme kann also über dessen Kontaktkühlfläche 7 und das damit verlötete Einpressteil 15 über die gesamte Fläche des Einpressteils 15 auf dem Kühldom 31 und darüber nach außen abgeleitet werden.

Das Ausführungsbeispiel gemäß Figur 6 unterscheidet sich von den vorausgegangenen Ausführungsbeispielen lediglich dadurch, dass zwischen der Unterseite 15b des Einpressteiles 15 und der Oberseite 31a des Kühldoms 31 noch eine Wärmeleitfolie 33 eingefügt ist. Diese eröffnet die Möglichkeit, geringstfügige Oberflächenunebenheiten auszugleichen, so dass eine vollflächige Verbindung unter Vermeidung von Lufteinschlüssen oder Luftspalten zwischen dem Einpressteil 15 und dem Kühldom 31 gewährleistet ist.

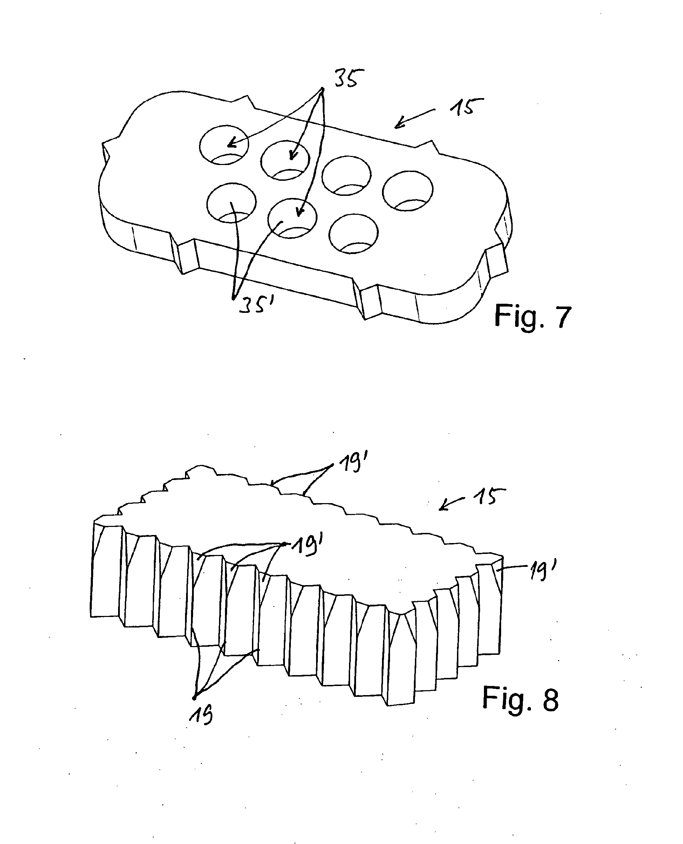

Anhand von Figur 7 ist eine Abwandlung für das Einpressteil 15 gezeigt. Das Einpressteil gemäß Figur 7 ist mit einer Perforation 35 versehen, also einer Vielzahl von das Einpressteil durchsetzenden Löchern oder Öffnungen 35'. Wird dieses Einpressteil in die Leiterplatinenöffnung 13 eingepresst, so kann dieses Teil mit der Unterseite des SMD-Bauteiles 1 auch durch ein Schwalllöt-Bad verlötet werden, da in diesem Fall das fließfähige Lot durch die Öffnung 35' von unten her die Perforationen im Einpressteil 15 durchsetzt und bis zur Kontaktkühlfläche 7 an der Unterseite des Bauteils 1 gelangt. Auch der Abstandsspalt 25 wird in einem derartigen Schwalllötverfahren mit Lot gefüllt und dadurch geschlossen.

In Figur 8 ist eine Abwandlung für das Einpressteil 15 insoweit gezeigt, als hier eine Vielzahl von vorstehenden Spitzen oder Kanten 19 vorgesehen ist. Auch in diesem Fall ist eine Einführungsabschrägung 19' ausgebildet, um das Einpressteil leichter in die Leiterplatinenöffnung 13 einzuführen und dann innerhalb dieser Leiterplatinenöffnung 13 einzupressen.

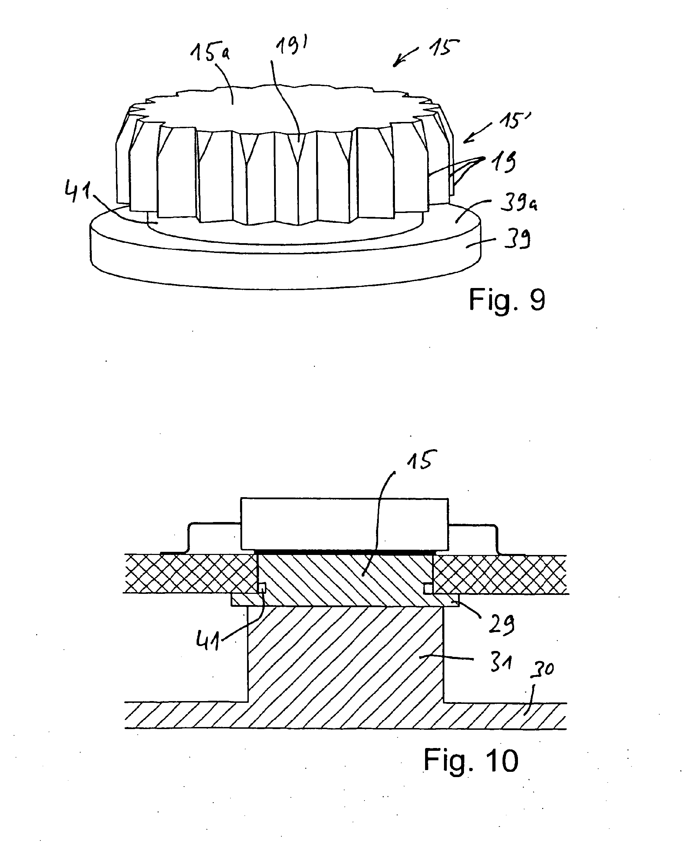

Anhand von Figur 9 ist ein abgewandeltes Ausführungsbeispiel mit einem umlaufenden Bund 39 und einer benachbart zum Bund verlaufenden Nut 41 vorgesehen. Zudem ist dieses Einpressteil 15 - nur zur Verdeutlichung der unterschiedlichen Ausführungsmöglichkeiten - als Rundteil ausgebildet.

Das in Figur 9 in schematischer perspektivischer Darstellung wiedergegebene Einpressteil 15 kann dann entsprechend der Schnittdarstellung nach Figur 10 in die Leiterplatinenöffnung 13 eingepresst werden, die in diesem Ausführungsbeispiel ebenfalls bevorzugt eher rund gestaltet ist. Die Oberseite 39a des Bundes 39 schlägt dann auf der Unterseite der Leiterplatine 11 an, so dass die maximale Einstecktiefe des Einpressteiles 15 in der Leiterplatinen-Öffnung 13 dadurch begrenzt ist. Die eigentliche über den Bund überstehende Höhe des Einpressteiles 15 ist so bemessen, dass die obere Niveaufläche 15a nicht über die obere Niveaufläche der Leiterplatine 11 übersteht. Die erwähnte Nut 41 bietet auch Vorteile bei der Herstellung der am Umfangsrand 15' ausgebildeten Spitzen, Keile 19 etc. Da in diesem Fall die Spitzen oder Keile, Stege oder Rippen 19 oberhalb der unteren Niveaufläche der Leiterplatinenöffnung 13 zu liegen kommen, hat diese eine Erhöhung der Auszugskräfte zur Folge, da hier ein gewisser Widerhakeneffekt gebildet wird. Zudem ist das Einpressteil als Drehteil kostengünstig herstellbar. Abweichend vom gezeigten Ausführungsbeispiel müssen die am Umfangsrand vorstehenden Rippen oder Spitzen nicht gleichmäßig am Umfangsrand verteilt sein. Sie können auch in größerem Seitenabstand zueinander in unregelmäßiger Folge vorgesehen sein.

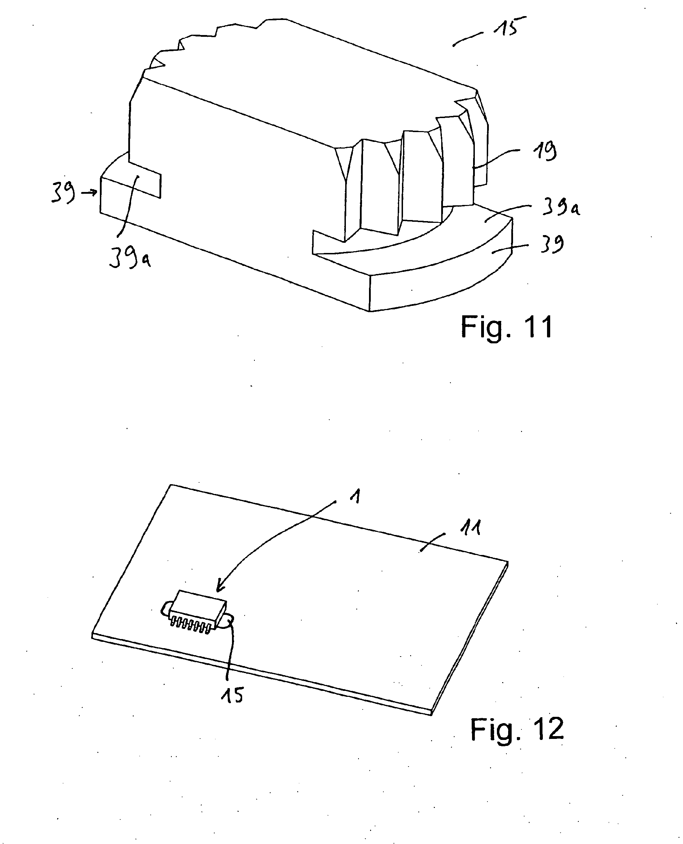

Figur 11 zeigt ein weiteres Abwandlungsbeispiel insoweit, als hier in Abweichung zum Ausführungsbeispiel entsprechend den Figuren 8 und 9 zwei gegenüberliegende planparalelle Abflachungen 43 ausgebildet sind. Dieses Einpressteil ist für Langlöcher in der Leiterplatine 11 geeignet. Da es grundsätzlich aber aus einem runden Teil gebildet ist, lässt es sich kostengünstig auf einer Drehmaschine herstellen.

Anhand von Figur 12 ist lediglich gezeigt, dass grundsätzlich das als Einpressteil 15 dienende Kühlplättchen bzw. der auch so bezeichnete Kühlblock zum Beispiel in Längsrichtung des Bauteiles 1 länger dimensioniert sein kann als das Bauteil 1 selbst. Somit überragt also der Kühlbock das Bauelement 1. Dies führt zu einer besseren Erwärmung des Kühlblocks beim Reflow-Löten.

## Patentansprüche

1. Leiterplatine mit gekühltem Baustein, insbesondere SMD-Baustein, mit auf der Leiterplatine (11) angelöteten Anschlussfüßchen (3), mit folgenden Merkmalen:
- in der Leiterplatine (11) ist eine Leiterplatinenöffnung (13) vorgesehen,
- der zu kühlende Baustein (1) weist auf seiner Unterseite (5) eine Kontakt-Kühlfläche (7) auf,
- die Kontakt-Kühlfläche (7) ist im Bereich der Leiterplatinenöffnung (13) angeordnet,
- innerhalb der Leiterplatinenöffnung (13) ist ein wärmeleitfähiges Einlegeteil in Form eines Kühlplättchen oder Kühlblocks positioniert,
- das Einlegeteil besteht aus einem Einpressteil (15), welches in der Leiterplatinenöffnung (13) durch einen Presssitz positioniert und mit der Kontakt-Kühlfläche (7) des Bausteins (1) verlötet ist, und
- unterhalb des Einpressteiles (15) ist ein Kühldom (31) angeordnet,
**gekennzeichnet durch** die folgenden weiteren Merkmale:
- das Einpressteil (15) ist mit zumindest einem Loch (35, 35') versehen, welches das Einpressteil (15) von seiner Ober- zu seiner Unterseite (15a, 15b) durchsetzt, und/oder
- das Einpressteil (15) weist zur verbesserten Aufheizung des Einpressteils (15) beim Reflow-Löten zur Erzielung einer optimalen Lötung zwischen der Kontakt-Kühlfläche (7) auf der Unterseite des Bausteins (1) und dem Einpressteil (15) eine Längserstreckung parallel zur Ebene der Leiterplatine (11) auf, die größer dimensioniert ist, als die entsprechende Erstreckung des elektrischen Bausteins (1), wobei die Anschlussfüßchen (3) an zwei quer zur Längsrichtung des Bausteins (1) gegenüberliegenden Seiten (1') vorgesehen sind.

2. Leiterplatine mit gekühltem Baustein nach Anspruch 1, **dadurch gekennzeichnet, dass** das Einpressteil (15) mit einer Vielzahl von Löchern (35, 35') versehen ist, welche das Einpressteil (15) von seiner Ober- zu seiner Unterseite (15a, 15b) durchsetzen.

3. Leiterplatine mit gekühltem Baustein nach Anspruch 1 oder 2, **dadurch gekennzeichnet, dass** das Einpressteil (15) an seinem Umfangsrand (15') und/oder der das Einpressteil (15) umgebende Rand der in Leiterplatine (11) vorgesehenen Leiterplatinenöffnung (13) mit Vorsprüngen und/oder Vertiefungen versehen ist, worüber das Einpressteil (15) in der Leiterplatinenöffnung (13) an der Leiterplatine (11) verankert ist.

4. Leiterplatine mit gekühltem Baustein nach einem der Ansprüche 1 bis 3, **dadurch gekennzeichnet, dass** zwischen den in das Leiterplatinenmaterial eingepressten Vorsprüngen (19) des Einpressteiles (15) oder zwischen den am Umfangsrand der Leiterplatinenöffnung (13) vorstehenden Vorsprüngen ein Abstandsspalt (25) zwischen dem Einpressteil (15) und dem angrenzenden Rand (11b) der Leiterplatinenöffnung (13) besteht.

5. Leiterplatine mit gekühltem Baustein nach einem der Ansprüche 1 bis 4, **dadurch gekennzeichnet, dass** das Einpressteil (15) zumindest partiell mit der Leiterplatine (11) verlötet ist.

6. Leiterplatine mit gekühltem Baustein nach Anspruch 5, **dadurch gekennzeichnet, dass** auf der Oberfläche des Einpressteiles (15) und vorzugsweise zumindest daran angrenzend benachbart zur Leiterplatinenöffnung (13) im Bereich der Leiterplatine (11) eine Vielzahl von Lötpasten-Punkten oder Lötpasten-Pads (27) vorgesehen sind, mittels derer eine Lötverbindung zum Bauteil (1) hergestellt ist.

7. Leiterplatine mit gekühltem Baustein nach Anspruch 6, **dadurch gekennzeichnet, dass** zumindest einige Lötpasten-Punkte oder Lötpasten-Pads (27) den Abstandsspalt (25) partiell überdecken.

8. Leiterplatine mit gekühltem Baustein nach einem der Ansprüche 1 bis 7, **dadurch gekennzeichnet, dass** die Vorsprünge (19) das als Kühlblock dienende Einpressteil (15) in der Leiterplatinenöffnung (13) zentrieren.

9. Leiterplatine mit gekühltem Baustein nach einem der Ansprüche 1 bis 8, **dadurch gekennzeichnet, dass** das Einpressteil (15) die Leiterplatinen-Bestückungsebene (11a) nicht überragt.

10. Leiterplatine mit gekühltem Baustein nach einem der Ansprüche 1 bis 9, **dadurch gekennzeichnet, dass** die am Umfangsrand des Einpressteils (15') ausgebildeten Vorsprünge (19) in Einsteckrichtung rippenförmig verlaufend gestaltet sind.

11. Leiterplatine mit gekühltem Baustein nach einem der Ansprüche 1 bis 10, **dadurch gekennzeichnet, dass** die Vorsprünge (19) in Einsteckrichtung in die Leiterplatinenöffnung (13) mit Einführungsschrägen (19') versehen sind.

12. Leiterplatine mit gekühltem Baustein nach Anspruch 11, **dadurch gekennzeichnet, dass** die Einführungsschräge (19') derart gebildet ist, dass die Höhe der vorstehenden Rippen entgegengesetzt zu ihrer Einsteckrichtung zumindest in einem Teilabschnitt der Rippe zunimmt.

13. Leiterplatine mit gekühltem Baustein nach Anspruch 11, **dadurch gekennzeichnet, dass** die Einführungsschräge (19') als an der vorstehenden Rippe in einer Teilhöhe ausgebildete Abflachung ausgebildet ist.

14. Leiterplatine mit gekühltem Baustein nach einem der Ansprüche 1 bis 13, **dadurch gekennzeichnet, dass** eine Vielzahl von Rippen (19) am umlaufenden Rand (15') des Einpressteiles ausgebildet sind.

15. Leiterplatine mit gekühltem Baustein nach einem der Ansprüche 1 bis 14, **dadurch gekennzeichnet, dass** das Einpressteil (15) als Drehteil ausgebildet oder durch Bearbeitung von seitlichen Abflachungen aus einem Drehteil gebildet ist.

16. Leiterplatine mit gekühltem Baustein nach einem der Ansprüche 1 bis 15, **dadurch gekennzeichnet, dass** das Einpressteil (15) an seiner Unterseite (15b) einen Bund (39) aufweist, dessen Oberseite (39a) im positionierten Zustand an der Leiterplatinen-Unterseite anliegt.

17. Leiterplatine mit gekühltem Baustein nach Anspruch 16, **dadurch gekennzeichnet, dass** angrenzend an die Oberseite (39a) des Bundes (39) eine Nut (41) am Einpressteil (15) ausgebildet ist, die von den seitlich vorstehenden Vorsprüngen (19) überragt wird.

18. Leiterplatine mit gekühltem Baustein nach Anspruch 17, **dadurch gekennzeichnet, dass** die Höhe der Vorsprünge (19) niedriger ist als die Leiterplatinen-Dicke.

19. Leiterplatine mit gekühltem Baustein nach einem der Ansprüche 1 bis 18, **dadurch gekennzeichnet, dass** die Oberseite des Einpressteils (15) mit der an der Unterseite des Bausteins (1) ausgebildeten Kontakt-Kühlfläche (7) verklebt oder verlötet ist.

20. Leiterplatine mit gekühltem Baustein nach einem der Ansprüche 1 bis 19, **dadurch gekennzeichnet, dass** zwischen der Oberseite des Einpressteiles (15) und der Unterseite des zu kühlenden Bausteines (1) Wärmeleitpaste aufgebracht ist.

21. Leiterplatine mit gekühltem Baustein nach einem der Ansprüche 1 bis 20, **dadurch gekennzeichnet, dass** zwischen der Oberseite des Einpressteiles (15) und der Unterseite des zu kühlenden Bausteines (1) eine Wärmeleitfolie (33) angeordnet ist.

22. Leiterplatine mit gekühltem Baustein nach einem der Ansprüche 1 bis 21, **dadurch gekennzeichnet, dass** die Unterseite (15b) des Einpressteils (15) in Kontaktanlage zu einem Kühldom (31), der vorzugsweise Teil eines Gehäuses (30)ist, angeordnet ist, vorzugsweise unter vollflächiger Zwischenfügung einer Wärmeleitfolie.

23. Leiterplatine mit gekühltem Baustein nach einem der Ansprüche 1 bis 22, **dadurch gekennzeichnet, dass** zumindest die Oberseite (15a), zumindest die Unterseite (15b) oder das gesamte Einpressteil (15) lötbar bzw. aus lötfähigem Material besteht oder mit einer lötfähigen Oberfläche versehen ist.

24. Leiterplatine mit gekühltem Baustein nach einem der Ansprüche 1 bis 23, **dadurch gekennzeichnet, dass** das Einpressteil (15) auf den Kühldom geschraubt ist.

25. Leiterplatine mit gekühltem Baustein nach einem der Ansprüche 1 bis 24, **dadurch gekennzeichnet, dass** die Dicke des Einpressteiles (15) und/oder der innerhalb der Leiterplatinenöffnung (13) zu liegende Teil des Einpressteils (15) gleich oder niedriger ist als die Leiterplatinen-Dicke.

26. Leiterplatine mit gekühltem Baustein nach einem der Ansprüche 1 bis 25, **dadurch gekennzeichnet, dass** der im zu kühlenden Baustein (1) integrierte Kühlkörper und das Einpressteil (15) beim Reflow-Löten miteinander verlötet sind.

## Claims

1. Printed circuit board having a cooled module, in particular an SMD module, having connecting feet (3) soldered to the printed circuit board (11), having the following features:
- an opening (13) is provided in the printed circuit board (11),
- the module (1) to be cooled has an area (7) for contact cooling on its underside (5),
- the area (7) for contact cooling is arranged in the region of the opening (13) in the printed circuit board,
- an insert able to conduct heat, in the form of a cooling plate or cooling block, is positioned in the opening (13) in the printed circuit board,
- the insert comprises a pressed-in part (15) that is positioned in the opening (13) in the printed circuit board by press-fitting and that is soldered to the area (7) for contact cooling of the module (1), and
- a cooling dome (31) is arranged below the pressed-in part (15),
**characterised by** the following further features:
- the pressed-in part (15) is provided with at least one hole (35, 35') that passes through the pressed-in part (15) from its upper side to its underside (15a, 15b), and/or
- for improved heating-up of the pressed-in part (15) in reflow soldering, to allow an optimum soldered joint to be obtained between the area (7) for contact cooling on the underside of the module (1) and the pressed-in part (15) the pressed-in part (15) is of a longitudinal extent parallel to the plane of the printed circuit board (11) that is larger in size than the corresponding extent of the electrical module (1), the connecting feet (3) being provided on two sides (1') that are in opposite positions transversely to the longitudinal direction of the module (1).

2. Printed circuit board having a cooled module, according to Claim 1, **characterised in that** the pressed-in part (15) is provided with a plurality of holes (35, 35') that pass through the pressed-in part (15) from its upper side to its underside (15a, 15b).

3. Printed circuit board having a cooled module, according to Claim 1 or 2, **characterised in that** the pressed-in part (15) is provided at its circumferential edge (15') with projections and/or depressions, and/or that edge of the opening (13) provided in the printed circuit board (11) that surrounds the pressed-in part (15) is provided with projections and/or depressions, by which means the pressed-in part (15) is anchored to the printed circuit board (11) in the opening (13) in the printed circuit board (11).

4. Printed circuit board having a cooled module, according to any one of Claims 1 to 3, **characterised in that**, between the projections (19) on the pressed-in part (15) that are pressed into the material of the printed circuit board or between the projections that project from the circumferential edge of the opening (13) in the printed circuit board, there is a spacing gap (25) between the pressed-in part (15) and the adjoining edge (11b) of the opening (13) in the printed circuit board.

5. Printed circuit board having a cooled module, according to any one of Claims 1 to 4, **characterised in that** the pressed-in part (15) is at least partly soldered to the printed circuit board (11).

6. Printed circuit board having a cooled module, according to Claim 5, **characterised in that** a plurality of soldering paste dots or soldering paste pads (27), by means of which a soldered connection is made to the component (1), are provided on the surface of the pressed-in part (15), and preferably at least adjacent thereto close to the opening (13) in the printed circuit board, in the region of the printed circuit board (11).

7. Printed circuit board having a cooled module, according to Claim 6, **characterised in that** at least some of the soldering paste dots or soldering paste pads (27) partly cover over the spacing gap (25).

8. Printed circuit board having a cooled module, according to any one of Claims 1 to 7, **characterised in that** the projections (19) centre the pressed-in part (15) acting as a cooling block in the opening (13) in the printed circuit board.

9. Printed circuit board having a cooled module, according to any one of Claims 1 to 8, **characterised in that** the pressed-in part (15) does not project beyond the plane (11a) in which components are fitted to the printed circuit board.

10. Printed circuit board having a cooled module, according to any one of Claims 1 to 9, **characterised in that** the projections (19) formed at the circumferential edge of the pressed-in part (15') are shaped to extend in a ridge-like shape in the direction of insertion.

11. Printed circuit board having a cooled module, according to any one of Claims 1 to 10, **characterised in that** the projections (19) are provided with lead-in inclinations (19') in the direction of insertion into the opening (13) in the printed circuit board.

12. Printed circuit board having a cooled module, according to Claim 11, **characterised in that** the lead-in inclination (19') is so formed that, in the direction opposite to their direction of insertion, the height of the projecting ridges increases at least in a part of the said ridges.

13. Printed circuit board having a cooled module, according to Claim 11, **characterised in that** the lead-in inclination (19') is in the form of a flat that is formed on the projecting ridge over part of its height.

14. Printed circuit board having a cooled module, according to any one of Claims 1 to 13, **characterised in that** a plurality of ridges (19) are formed at the surrounding edge (15') of the pressed-in part.

15. Printed circuit board having a cooled module, according to any one of Claims 1 to 14, **characterised in that** the pressed-in part (15) is in the form of a turned part, or is formed from a turned part by the machining of lateral flats.

16. Printed circuit board having a cooled module, according to any one of Claims 1 to 15, **characterised in that** the pressed-in part (15) has, on its underside (15b), a collar (39) whose upper side (39a) rests against the underside of the printed circuit board in the positioned state.

17. Printed circuit board having a cooled module, according to Claim 16, **characterised in that**, adjacent the upper side (39a) of the collar (39), there is formed in the pressed-in part (15) a groove (41) beyond which the projections (19) projecting from the sides project.

18. Printed circuit board having a cooled module, according to Claim 17, **characterised in that** the height of the projections (19) is less than the thickness of the printed circuit board.

19. Printed circuit board having a cooled module, according to any one of Claims 1 to 18, **characterised in that** the upper side of the pressed-in part (15) is adhesive-bonded or soldered to the area (7) for contact cooling formed on the underside of the module (1).

20. Printed circuit board having a cooled module, according to any one of Claims 1 to 19, **characterised in that** thermally conductive paste is applied between the upper side of the pressed-in part (15) and the underside of the module (1) to be cooled.

21. Printed circuit board having a cooled module, according to any one of Claims 1 to 20, **characterised in that** a thermally conductive foil or film (33) is arranged between the upper side of the pressed-in part (15) and the underside of the module (1) to be cooled.

22. Printed circuit board having a cooled module, according to any one of Claims 1 to 21, **characterised in that** the underside (15b) of the pressed-in part (15) is arranged in contacting abutment with a cooling dome (31) that is preferably part of a housing (30), preferably with a thermally conductive foil or film interinserted over the entire area.

23. Printed circuit board having a cooled module, according to any one of Claims 1 to 22, **characterised in that** at least the upper side (15a), at least the underside (15b), or the entire pressed-in part (15) is solderable or is composed of solderable material or is provided with a solderable surface.

24. Printed circuit board having a cooled module, according to any one of Claims 1 to 23, **characterised in that** the pressed-in part (15) is screwed to the cooling dome.

25. Printed circuit board having a cooled module, according to any one of Claims 1 to 24, **characterised in that** the thickness of the pressed-in part (15) and/or the part of the pressed-in part (15) that is to be situated in the opening (13) in the printed circuit board is equal to or less than the thickness of the printed circuit board.

26. Printed circuit board having a cooled module, according to any one of Claims 1 to 25, **characterised in that** the heat sink incorporated in the module (1) to be cooled and the pressed-in part (15) are soldered together in the reflow soldering.

## Revendications

1. Carte à circuits imprimés comportant un composant refroidi, en particulier un composant monté en surface "CMS", muni de pattes de connexion (3) brasées sur la carte à circuits imprimés (11), présentant les éléments suivants :
- une ouverture de carte à circuits imprimés (13) est prévue dans la carte à circuits imprimés (11),
- le composant (1) à refroidir présente sur sa face inférieure (5) une surface de refroidissement de contact (7),
- la surface de refroidissement de contact (7) est agencée dans la zone de l'ouverture de carte à circuits imprimés (13),
- à l'intérieur de l'ouverture de carte à circuits imprimés (13) est positionné un élément d'insertion conducteur de chaleur sous la forme d'une plaquette de refroidissement ou d'un bloc de refroidissement,
- l'élément d'insertion est constitué par un élément (15) enfoncé à la presse, qui est positionné par ajustement serré dans l'ouverture de carte à circuits imprimés (13) et brasé avec la surface de refroidissement de contact (7) du composant (1), et
- une coupole de refroidissement (31) est agencée au-dessous de l'élément (15) enfoncé à la presse,
**caractérisé par** les autres éléments suivants:
- l'élément (15) enfoncé à la presse est pourvu d'au moins un trou (35, 35') qui traverse l'élément (15) enfoncé à la presse depuis sa face supérieure vers sa face inférieure (15a, 15b), et/ou
- en vue d'un meilleur chauffage de l'élément (15) enfoncé à la presse lors du brasage par reflux, pour atteindre un brasage optimal entre la surface de refroidissement de contact (7) sur la face inférieure du composant (1) et l'élément (15) enfoncé à la pression, l'élément (15) enfoncé à la presse présente une extension longitudinale parallèlement au plan de la carte à circuits imprimés (11), qui est dimensionnée plus grande que l'extension correspondante du composant électrique (1), les pattes de connexion (3) étant prévues sur deux côtés opposés (1) transversalement à la direction longitudinale du composant (1).

2. Carte à circuits imprimés comportant un composant refroidi selon la revendication 1, **caractérisée en ce que** l'élément (15) enfoncé à la presse est pourvu d'une multitude de trous (35, 35') qui traversent l'élément (15) enfoncé à la presse depuis sa face supérieure vers sa face inférieure (15a, 15b).

3. Carte à circuits imprimés comportant un composant refroidi selon la revendication 1 ou 2, **caractérisée en ce que** sur son bord périphérique (15'), l'élément (15) enfoncé à la presse et/ou le bord entourant l'élément (15) enfoncé à la presse de l'ouverture de carte à circuits imprimés (13) prévue dans la carte à circuits imprimés (11) est pourvu de saillies et/ou de cavités, par lesquelles l'élément (15) enfoncé à la presse est ancré dans l'ouverture de carte à circuits imprimés (13) sur la carte à circuits imprimés (11).

4. Carte à circuits imprimés comportant un composant refroidi selon l'une des revendications 1 à 3, **caractérisée en ce que** entre les saillies (19), enfoncées dans le matériau de la carte à circuits imprimés, de l'élément (15) enfoncé à la presse ou entre les saillies dépassant du bord périphérique de l'ouverture de carte à circuits imprimés (13), il existe un intervalle d'écartement (25) entre l'élément (15) enfoncé à la presse et le bord adjacent (11b) de l'ouverture de carte à circuits imprimés (13).

5. Carte à circuits imprimés comportant un composant refroidi selon l'une des revendications 1 à 4, **caractérisée en ce que** l'élément (15) enfoncé à la presse est brasé au moins partiellement sur la carte à circuits imprimés (11).

6. Carte à circuits imprimés comportant un composant refroidi selon la revendication 5, **caractérisée en ce que** sur la surface de l'élément (15) enfoncé à la presse et de préférence au moins au voisinage adjacent à l'ouverture de carte à circuits imprimés (13), dans la zone de la carte à circuits imprimés (11), il est prévu une multitude de points de pâte de brasage ou de taches de pâte de brasage (27) au moyen desquel(le)s est réalisée une liaison brasée avec le composant (1).

7. Carte à circuits imprimés comportant un composant refroidi selon la revendication 6, **caractérisée en ce que** quelques-un(e)s au moins des points de pâte de brasage ou des taches de pâte de brasage (27) recouvrent partiellement l'intervalle d'écartement (25).

8. Carte à circuits imprimés comportant un composant refroidi selon l'une des revendications 1 à 7, **caractérisée en ce que** les saillies (19) centrent l'élément (15) enfoncé à la presse, servant de bloc de refroidissement, dans l'ouverture de carte à circuits imprimés (13).

9. Carte à circuits imprimés comportant un composant refroidi selon l'une des revendications 1 à 8, **caractérisée en ce que** l'élément (15) enfoncé à la presse ne dépasse pas au-delà du plan d'équipement (11) de la carte à circuits imprimés.

10. Carte à circuits imprimés comportant un composant refroidi selon l'une des revendications 1 à 9, **caractérisée en ce que** les saillies (19) réalisées au bord périphérique de l'élément (15') enfoncé à la presse sont réalisées de manière à s'étendre en forme de nervures en direction d'enfichage.

11. Carte à circuits imprimés comportant un composant refroidi selon l'une des revendications 1 à 10, **caractérisée en ce que** les saillies (19) sont pourvues de pentes d'introduction (19') dans la direction d'enfichage dans l'ouverture de carte à circuits imprimés (13).

12. Carte à circuits imprimés comportant un composant refroidi selon la revendication 11, **caractérisée en ce que** la pente d'introduction (19') est formée de telle sorte que la hauteur des nervures saillantes augmente en sens opposé à sa direction d'extension au moins dans un tronçon partiel de la nervure.

13. Carte à circuits imprimés comportant un composant refroidi selon la revendication 11, **caractérisée en ce que** la pente d'introduction (19') est réalisée sous forme de méplat réalisé sur la nervure saillante à une hauteur partielle.

14. Carte à circuits imprimés comportant un composant refroidi selon l'une des revendications 1 à 13, **caractérisée en ce qu'**une multitude de nervures (19) sont réalisées sur le bord périphérique (15') de l'élément enfoncé à la presse.

15. Carte à circuits imprimés comportant un composant refroidi selon l'une des revendications 1 à 14, **caractérisée en ce que** l'élément (15) enfoncé à la presse est réalisé au tour ou par usinage de méplats latéraux à partir d'un élément réalisé au tour.

16. Carte à circuits imprimés comportant un composant refroidi selon l'une des revendications 1 à 15, **caractérisée en ce que** l'élément (15) enfoncé à la presse présente sur sa face inférieure (15b) un collier (39) dont la face supérieure (39a) s'appuie contre la face inférieure de la carte à circuits imprimés, dans l'état positionné.

17. Carte à circuits imprimés comportant un composant refroidi selon la revendication 16, **caractérisée en ce qu'**une gorge (41) est ménagée dans l'élément (15) enfoncé à la presse de façon adjacente à la face supérieure (39a) du collier (39), gorge qui est dépassée par les saillies (19) dépassant latéralement.

18. Carte à circuits imprimés comportant un composant refroidi selon la revendication 17, **caractérisée en ce que** la hauteur des saillies (19) est inférieure à l'épaisseur de la carte à circuits imprimés.

19. Carte à circuits imprimés comportant un composant refroidi selon l'une des revendications 1 à 18, **caractérisée en ce que** la face supérieure de l'élément (15) enfoncé à la presse est collée ou brasée sur la surface de refroidissement de contact (7) réalisée sur la face inférieure du composant (1).

20. Carte à circuits imprimés comportant un composant refroidi selon l'une des revendications 1 à 19, **caractérisée en ce qu'**une pâte thermoconductrice est appliquée entre la face supérieure de l'élément (15) enfoncé à la presse et la face inférieure du composant à refroidir (1).

21. Carte à circuits imprimés comportant un composant refroidi selon l'une des revendications 1 à 20, **caractérisée en ce qu'**une feuille thermoconductrice (33) est agencée entre la face supérieure de l'élément (15) enfoncé à la presse et la face inférieure du composant à refroidir (1).

22. Carte à circuits imprimés comportant un composant refroidi selon l'une des revendications 1 à 21, **caractérisée en ce que** la face inférieure (15) de l'élément (15) enfoncé à la presse est agencée en appui de contact contre une coupole de refroidissement (31) qui fait de préférence partie d'un boîtier (30), de préférence avec interposition sur toute la surface d'une feuille thermoconductrice.

23. Carte à circuits imprimés comportant un composant refroidi selon l'une des revendications 1 à 22, **caractérisée en ce qu'**au moins la face supérieure (15a), au moins la face inférieure (15b) ou l'ensemble de l'élément (15) enfoncé à la presse est capable d'être brasé(e) ou constitué(e) d'un matériau capable d'être brasé ou encore pourvu(e) d'une surface capable d'être brasée.

24. Carte à circuits imprimés comportant un composant refroidi selon l'une des revendications 1 à 23, **caractérisée en ce que** l'élément (15) enfoncé à la presse est vissé sur la coupole de refroidissement.

25. Carte à circuits imprimés comportant un composant refroidi selon l'une des revendications 1 à 24, **caractérisée en ce que** l'épaisseur de l'élément (15) enfoncé à la presse et/ou la partie, venant se trouver à l'intérieur de l'ouverture de carte à circuits imprimés (13), de l'élément (15) enfoncé à la presse est égale ou inférieure à l'épaisseur de la carte à circuits imprimés.

26. Carte à circuits imprimés comportant un composant refroidi selon l'une des revendications 1 à 25, **caractérisée en ce que** le corps de refroidissement intégré dans le composant (1) à refroidir et l'élément (15) enfoncé à la presse sont brasés l'un sur l'autre lors du brasage par reflux.
